(19) Europäisches Patentamt

European Patent Office

Office européen des brevets

(11) **EP 4 397 397 A1**

(12) **EUROPEAN PATENT APPLICATION**

(43) Date of publication:
**10.07.2024  Bulletin 2024/28**

(21) Application number: **23150340.0**

(22) Date of filing: **04.01.2023**

(51) International Patent Classification (IPC):
**B01D 63/08** (2006.01)        **B01D 69/10** (2006.01)

(52) Cooperative Patent Classification (CPC):
**B01D 69/1071; B01D 63/087;** B01D 61/14;
B01D 2313/025; B01D 2313/04

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Novamem AG
8952 Schlieren (CH)**

(72) Inventors:
• **Loepfe, Michael
8006 Zürich (CH)**
• **Kellenberger, Christoph Ruedi
8127 Forch (CH)**

(74) Representative: **Hepp Wenger Ryffel AG
Friedtalweg 5
9500 Wil (CH)**

(54)    **METHOD OF MANUFACTURING A MICROPOROUS POLYMER STRUCTURE**

(57)    A method of manufacturing a microporous polymer structure (1) with at least one porous region (2) and a substantially non-porous support structure (3) configured to support said at least one porous region (2), the method comprising the steps of: i) providing a substrate (4); ii) providing a first composition (5) comprising a first polymer (5a), at least one solvent (5b) for said first polymer, and one or both of nanoparticles and microparticles (5c) dispersed within said first composition (5); iii) providing a second composition (6) comprising a second polymer (6a); iv) applying the first composition (5) to a surface (4a) of said substrate (4) to form a first coating layer (7); v) effecting a phase separation in the first coating layer (7) to obtain a phase separated coating layer (7'); vi) applying the second composition (6) to the same surface (4a) of said substrate (4) and/or onto the phase separated first coating layer (7'); vii) physically hardening or curing the second composition (6) applied in step vi) to obtain the non-porous support structure (3); viii) dissolving said nanoparticles and/or microparticles (5c) with a washing solvent to obtain the porous region (2); wherein said non-porous support structure and said porous regions are arranged on the substrate such that they form common interfaces, and wherein the phase separation in the first coating layer (7) in step v) is effected from one side of the first coating layer (7).

Fig. 2b

## Description

The present invention relates to a method of manufacturing a microporous polymer structure, a microporous polymer structure, and a filtration device according to the independent claims.

Filtration is a common method used to separate solids from fluids using a porous filter membrane. Particles smaller than the membrane pores can still pass this mechanical barrier, whereas larger particles are accumulated on the feed side. Depending on the actual pore size, membranes are classed as microfiltration with pore sizes down to 100 nm and ultrafiltration with pore sizes between 2 and 100 nm. When going down to nanofiltration, i.e. pore sizes between 0.5 and 2 nm, and reverse osmosis with pore sizes below 0.5 nm, separation rather occurs due to the mechanical barrier of polymer strands rather than an actual pore.

Micro- and ultrafiltration membranes are generally made via phase inversion processes, e.g. as described in U.S. 6,267,916 B1. They involve the casting of a polymer dope solution onto a substrate and subsequent quenching of the dope solution. During this precipitation step, pores are formed in the polymer layer. Such a process is also known under the name of non-solvent induced phase separation (NIPS). Instead of using a non-solvent, separation may also be induced by reducing temperature of a casted polymer dope solution. Such temperature induced phase separation (TIPS) process is further illustrated, for example, in U.S. 5,444,097 A.

Besides membrane manufacturing processes based on any kind of phase separation, manufacturing processes using plain or coated template particles for a pore have shown great potential and relevance for large scale membrane manufacturing. As described, for example, in EP 2 665 767 A1, this process uses nano- and/or microparticles as pore templates to form a polymer-template composite. In a subsequent step, the template particles are dissolved to reveal the porous membrane structure. As a high porosity is important for achieving a high permeability, this template-based process offers a simple control over the desired porosity by the bare amount of template particles used.

However, the higher the porosity the poorer the mechanical properties of a porous membrane become, regardless of the manufacturing method used. To some extent, the deterioration of the mechanical properties can be counteracted by incorporation of a porous support such as a woven or non-woven to form a composite porous membrane, as described in EP 1 666 129 B1, for example, but this in turn compromises permeability.

In order to improve the mechanical membrane properties while keeping it free-standing, one may of course increase the thickness of the membrane, but this reduces the manufacturing speed due to the extra solvent involved. Moreover, permeability is also compromised as the flow resistance scales with the square of the pore diameter and the pore length. Hence, thick membranes with small pores are thus particularly prone to comparably low permeability.

Recently, processes were developed to produce asymmetric membranes which may provide a good compromise between mechanical stability and permeability. By way of example, U.S. 6,736,971 B2 and U.S. 8,123,992 B2 describe a set-up producing a two-layered membrane with different porosities. This way, the selective layer with the smaller pores may be made thinner without losing the stability of a generally thicker membrane. However, a smooth transition or gradient of the pore sizes between bottom and top side or surface, which would be most beneficial, is not achieved by these membranes.

Besides the need for highly permeable membranes, it is commonly also required that the membranes can be securely sealed against a filter housing in which they are housed. Sealing can be effected by gluing or welding the membrane edges together or into a sealing cap. While gluing is considered to be simpler, additives of the glue may leach later on which may be an issue, especially if the membrane is intended for use in drinking water applications or in a pharmaceutical environment. Hence, thermal bonding, such as ultrasonic welding or infrared welding, is a preferred way to seal membrane edges without adding to the risk of leachable components. Nevertheless, this method has certain drawbacks, in particular the fact that it exerts thermal and mechanical stress on the membrane, which can damage the porous regions and negatively affect membrane performance. It would be desirable if the membrane had sealing areas with ideally no porosity and filter areas with high and asymmetric porosity.

It is an object of the present invention to overcome these and other drawbacks of the prior art and in particular to provide an improved method of manufacturing a microporous polymer structure, in particular a membrane, which enables control over the porosity within the microporous polymer structure, which is cost-effective, re-liable and easy to perform. It is a further object to provide a microporous polymer structure, in particular a membrane, which can be safely and easily attached to a partner, e.g. a filter housing, and which features a high asymmetric porosity while maintaining good mechanical stability.

The object is achieved by a method of manufacturing a microporous polymer structure with at least one porous region and a substantially non-porous support structure configured to support said at least one porous region, a microporous polymer structure, and a filtration device comprising at least one microporous polymer structure as disclosed herein, pursuant to the independent claims. Advantageous embodiments are subject to the dependent claims.

In the context of the present invention, the term "non-porous" means that the respective region comprises essentially no interconnected pores.

The term "and/or" as used herein includes any and all combinations of one or more of the associated listed items.

The method of manufacturing a microporous polymer structure with at least one porous region and a substantially non-porous support structure configured to support said at least one porous region comprises the following steps:

> In step a), a substrate is provided. The substrate may in particular be a porous substrate or a non-porous substrate selected from the group consisting of fabric, non-woven, foam, synthetic polymer, biopolymer, ceramic, metal, glass, and combinations thereof. In addition or alternatively, the substrate may have a two-dimensional or a three-dimensional shape.

> In step b) a first composition is provided. The first composition comprises a first polymer, at least one solvent for said first polymer, and one or both of nanoparticles and microparticles dispersed within said first composition.

The first polymer may in particular be one or more polymers selected from the group consisting of polysulfones, polyethersulfones, polycarbonates, polystyrenes, polyacrylates, polysiloxanes, polyarylates, polyurethanes, polyesters, polyethers, polyimides, polyamides, halogenated polyolefins, cellulose acetates and liquid crystal polymers. Alternatively, the first polymer may be a polymer or copolymer as mentioned in the preceding sentence, which is/are functionalized via postpolymerization, sulfonation phosphorylation, amination, quaternization. Additionally or alternatively, it is also conceivable that the first polymer may be selected from the group consisting of oligomers that can be polymerized or polymers that can be crosslinked. The use of oligomers affords a lower viscosity and can facilitate the coating of the substrate, particularly when the substrate features a complex shape or when complete coverage of the substrate is desired. Cross-linking can enhance the durability of the coating and/or the free-standing microporous polymer structure after its removal from the substrate, respectively.

Suitable solvents for the first polymer may be selected based on the respective polymer or polymers to be dissolved as will be understood by the person skilled in the art. It is preferred if the solvents for the first polymer feature a boiling point below 230 °C. In this temperature range, energy savings are possible compared to solvents with higher boiling points, and the risk of damaging the microporous polymer structure due to thermal or thermooxidative stress is also reduced. Examples of suitable solvents for the first polymer include water or organic solvents selected from the group consisting of alcohols, ethers, ketones, esters, halogen-alkanes, alkanes, cycloalkanes, sulfoxides, amides, pyrrolidones, lactones and lactames.

The first composition may comprise one or more additives selected from a broad range of known additives and mixtures thereof that are known in the field. Particularly, additives may be selected from the group consisting of surfactants, polymerisation initiators, stabilizers, cross-linking agents, wetting agents, thickeners, curing agents, leveling agents, film flow agents, film uniformity agents, anti-foaming agents, anti-orange peel agents, and mixtures thereof. In a preferred embodiment, the first composition comprises at least one hydrophilicity enhancing additive, in particular such as those disclosed in WO 02/42530 A1. The use of one or more hydrophilicity enhancing additives is in order to reduces the adhesion of air bubbles or other hydrophobic substances in the pores, which would adversely affect flow.

In step c), a second composition is provided. The second composition comprises a second polymer and optionally at least one solvent for said second polymer.

The first polymer and/or the second polymer may be selected from the group consisting of polysulfones, polyethersulfones, polycarbonates, polystyrenes, polyacrylates, polysiloxanes, polyarylates, polyurethanes, polyesters, polyethers, polyimides, polyamides, halogenated polyolefins, cellulose acetates, liquid crystal polymers, and precursors thereof.

Suitable solvents for the second polymer may be selected based on the respective polymer or polymers to be dissolved, as will be understood by the person skilled in the art.

In step d), the first composition is applied to a surface of the substrate provided in step a), in order to form a first coating layer on said substrate.

In an optional step e), the first coating layer formed in step d) is subjected to an atmosphere promoting the evaporation of at least one of the solvents for the first polymer.

In step f), a phase separation is effected in the first coating layer to obtain a phase separated first coating layer. The phase separation in the first coating layer in step f) is effected from one side of the first coating layer. This is in order to generate asymmetric structures in the first coating layer which will later become the porous region of the microporous polymer structure. Phase separation may be induced in the first coating layer by exposing it to a nonsolvent atmosphere (drying process) and/or by temperature change, as will be further described below. Preferably, the phase separation in the first coating layer in step f) is effected from the side of the substrate, which allows for particularly good control of this process step and minimizes the risk of damaging the unsupported surface facing away from the substrate.

In step g), the second composition is applied to the same surface of said substrate provided in step a) and coated with the first composition in step d). Application of the second composition is performed in a patterned manner depending on the desired or required shape of the support structure for supporting the porous regions. Additionally or alternatively, the second composition is applied, in a patterned manner, onto the phase separated first coating layer formed in step d).

In step h), the second composition applied in step g) is physically hardened (e.g., by way of evaporation of solvent) or cured to obtain the non-porous support structure. The non-porous support structure and the porous regions are arranged on the substrate such that they form common interfaces.

In step i), the nanoparticles and/or microparticles are dissolved with a washing solvent to obtain the porous region. In order to achieve faster dissolution, the nanoparticles and/or microparticles are preferably dissolved with acidic aqueous solution.

The "washing solvent" as described herein is a non-organic solvent (e.g. water) that is used to remove the salt particles from their polymer matrix, i.e. the phase separated first coating layer, by dissolution in said non-organic solvent. The washing solvent is characterized as such that it does not dissolve the polymer(s) comprised in the first and second composition used in the manufacturing process described herein. Further, the washing solvent is used in the method described herein preferably but not necessarily in a liquid aggregate state. It is also conceivable that step i) includes multiple washings and optional dryings between washings. When using a multi-step protocol including multiple washings, either the same or different washing solvents may be used, for example a diluted aqueous acid first, followed by water.

In an optional step j), the microporous polymer structure obtained after step i) is dried. Drying may be performed up to a predefined weight loss or weight constancy.

The microporous polymer structure disclosed herein may in particular be a membrane and, concomitantly, the method herein is in particular one of manufacturing a membrane.

The method of manufacturing a microporous polymer structure disclosed herein is cost-effective, reliable and easy to perform. The method disclosed herein yields microporous polymer structures, in particular membranes, which differ structurally from membranes formed by lamination of two or more polymer films or extrusion processes in that the present microporous polymer structures feature a true asymmetric pore size distribution, which is furthermore achieved by phase separation.

The asymmetric microporous polymer structures provided by the present invention typically comprise a comparatively thin, e.g. 10 nm to 50 nm thin, dense separation layer and a comparatively thick porous layer, the latter providing mechanical stability and efficient transport of the filtrate. The asymmetric porous polymer structures as disclosed herein thus combine high permeate flow, provided by the separation or selective layer and a reasonable mechanical stability resulting from the comparatively thick, porous layer. Mechanical stability is significantly further enhanced by the substantially non-porous support structure as disclosed herein. Moreover, the microporous polymer structures disclosed herein exhibit a pore size gradient, which further distinguishes them from membranes formed by lamination of two or more polymer films.

The microporous polymer structures disclosed herein are self-supporting ("free-standing"). Therefore, they distinguish from known porous polymer structures of similar thickness and porosity on a support. However, the microporous polymer structures disclosed herein are equally suitable for coating an appropriate support. The possibility of manufacturing such microporous polymer structures independent from a specific support makes them very versatile.

The microporous polymer structures disclosed herein are useful for applications in the fields of ultrafiltration (UF) and microfiltration (MF), for example. Ultrafiltration is used to separate particles of 2 to 100 nm, such as viruses, proteins and colloids. Microfiltration is used to separate particles of 100 to 1000 nm, such as bacteria.

The method disclosed herein may further comprise a step k) of removing the microporous polymer structure from the substrate. In this embodiment, step k) is performed after any one of steps g) to j). This way, a free-standing microporous polymer structure, in particular a free-standing membrane, is obtained.

In a preferred embodiment of the method disclosed herein, step d) and step g) are performed simultaneously, followed by step f). This allows for a particularly fast and efficient method of manufacturing.

In a preferred embodiment of the method disclosed herein, application of the fist composition in step d) and/or application of the second composition in step g) are/is performed by means of solvent casting, extrusion or printing. The first and/or second composition can be processed or applied very well with the means indicated above. Printing is particularly preferred because it allows particularly fine or detailed structures to be produced, which is particularly advantageous when processing the second composition because the resulting support structure can concomitantly be designed particularly effectively.

In a preferred embodiment of the method disclosed herein, the phase separation in step f) is effected by applying heat of more than 40 °C to one side of the first coating layer, preferably from the side of the substrate. Heating from the side of the substrate, i.e. from the side facing away from the accessible surface of the first coating layer and through the substrate, reduces the risk of damage to this surface in the course of heating, e.g. due to convection, thereby allowing a higher surface quality to be achieved.

In a preferred embodiment of the method disclosed herein, the second composition comprises at least one of radiation-curable monomers, radiation-curable oligomers, and precursors of the second polymer. In this embodiment, curing of said second composition in step h) is performed by radiation curing using ultraviolet (UV) light or high-energy electrons from an electron-beam (EB) source.

When compared to curing by heat, the use of UV light to cure the second composition has the advantage that curing times are significantly reduced, allowing curing times generally in the range of a few seconds. This, in turn, is advantageous for high-throughput or continuous processes, as it eliminates the need for long drying sections with high space requirements and costs. Apart from improved turnaround times, UV curing of the second composition also allows the second composition to create finer, more well-defined structures because running of the second composition or mixing with the first composition is reduced by the rapid curing with UV light.

The UV light used to cure the second composition preferably has a wavelength of 280 to 400 nm. UV light of this wavelength range is capable of deep penetration curing that creates a tough coating in which the number of unreacted reactive groups, which may otherwise lead to leaching of the respective monomers or oligomers from the cured composition, is significantly reduced. This is particularly important in medical applications, where no harmful or even toxic compounds are to escape the porous polymer material.

A wide variety of polymers can be used for the inventive microporous polymer structures. This is considered advantageous, as the porous polymer structures known from the prior art are limited in view of the suitable materials and/or the characteristics of its pores.

In a preferred embodiment of the method disclosed herein, the first polymer and the second polymer are identical, i.e. the at least one first polymer comprised in the first composition and the at least one second polymer comprised in the second composition are the same polymers. This way, the complexity of the overall method can be reduced and costs can be reduced. However, it is also conceivable that the first polymer and the second polymer are not identical, i.e. the at least one first polymer comprised in the first composition and the at least one second polymer comprised in the second composition are different polymers. In the latter case, they are to be chosen by the skilled person in terms of solubility in the same solvent, their co-precipitation behavior, and/or their shrinking behavior.

In a preferred embodiment of the method disclosed herein, said nano- and/or microparticles are selected from the group consisting of oxides, carbonates, sulphates, halogenides, nitrates and phosphates. Preferably, the nano- and/or microparticles are selected from the group consisting of oxides and carbonates, most preferably calcium carbonate ($CaCO_3$), barium carbonate ($BaCO_3$), strontium carbonate ($SrCO_3$), sodium carbonate ($Na_2CO_3$), potassium carbonate ($K_2CO_3$), sodium chloride (NaCl), zinc oxide (ZnO) and calcium oxide (CaO). The aforementioned salts and oxides are generally readily available, reasonably priced, and readily dissolvable, especially under acidic aqueous conditions.

In addition or alternatively, the nano- and/or microparticles have a particle size of 1 to 5000 nm, preferably 5 to 600 nm. The aforementioned particle sizes represent a preferred compromise between pore size, porosity, inter-pore-connectivity, and particle leachability.

Pore size for particles with a particle size between 0.01 $\mu$m and 5 $\mu$m is determined by fluorescence read out of fluorescently labelled polystyrene or silica microspheres according to the following measurement protocol, in which a test particle with a size of 0.5 $\mu$m is given as an example:

(i) Preparation of challenge solution:

Fluorescent particles, available from ThermoFisher (FluoSpheres™, 0.5 $\mu$m, red fluorescent (580/605), F8812) or Micromod Partikeltechnologie GmbH (Product code: 42-00-502 sicastar®-greenF), are diluted with 0.01% by volume polyoxyethylene (20) sorbitan monooleate (Tween® 80) in deionized water to obtain a final particle concentration of 1:1000.

(ii) Beads retention testing

A specimen of the porous polymer structure to be analysed is mounted into a filter housing (effective filter area 6 to 20 cm$^2$) comprising a woven or nonwoven support structure (e.g. Novatexx 2413, Freudenberg) for supporting the specimen in the filter housing. The support must be such that mechanical stress onto the membrane is minimized and the membrane therefore does not stretch under pressure. A defined volume of challenge solution is poured into the thus obtained test cell. The challenge solution is passed through the specimen with an air-pressure of 1 to 6 bar such that inherent bubble point of the membrane is overcome and until the entire challenge solution volume is passed through the specimen. The permeate is discarded and the procedure (ii) is repeated. This time, the Permeate is collected in a clean plastic weighing pan for analysis.

(iii) Analysis

Deionized water, challenge solution and permeate (250 $\mu$L each) are pipetted into a well plate (e.g. 96 well plate). Fluorescent read out is performed with plate reader (e.g. Tecan), using the following protocol:

- 10s orbital shake, followed by,
- top readout of the red fluorescent particles without lid; Ex./Em. 540(25)/620(20) nm; Gain calculated from well with "full" signal, 25 flashes, 20 $\mu$s integration time, 3x3 square filled read out with 1000 $\mu$m border,
- Top readout of the green fluorescent particles without lid; Ex./Em. 465(20)/510(20) nm; Gain calculated from well with "full" signal, 25 flashes, 20 $\mu$s integration time, 3x3 square filled read out with 1000 $\mu$m border.

Readout of water represents blank signal, readout of challenge solution represents full signal and readout of permeate represents sample signal.

Retention R is then calculated from the well as follows:

$$R = \left(1 - \frac{sample - blank}{full - blank}\right) * 100\%$$

If R is larger than 90%, the challenge particles are filtered and the porous polymer structure is said to have a pore size smaller than the challenge particle size (in this example it would be 0.5 pm).

(iv) Adaption of dilution

If the fluorescent readout of the blank is equal or larger than 10% of the fluorescent readout of the full, dilution shall be reduced until blank is below 10% of full.

Pore size for particles with a particle size between 1 nm and 100 nm is determined by a dextran rejection test that has been implemented to determine the molecular weight cut-off (denoted as MWCO, for details see: G. Tkacik, S. Michaels, Nature Biotechnology. 9:941-946, 1991). A membrane capable of rejecting at least 90% of a macromolecule of 1000kDa can be classified to have a MWCO of 1000kDA. A 0.1wt% mixture of different dextran standards (5kDa, 25kDa, 80kDa, 150kDa, 270kDa, 410kDa, 670kDa, 1400kDa) (Fluka, CH) was prepared in 0.1M sodium nitrate (denoted as NaNO$_3$) buffer solution. The individual standards were mixed in equal amounts. The mixture was filtered (direct flow) through the membrane using a high vacuum pump (Edwards Vacuum Ltd). The permeate and the mixture were compared using gel permeation chromatography.

Hence, for example, the MWCO of a membrane showing a minimal rejection of 95% for the 1400kDa dextran standard molecules can be classified as 1400kDa.

In case the two methods described herein for determining the pore size lead to different results, the results obtained by fluorescence read out are decisive.

The pores of a material may be arranged in a way that the material is permeable, partly permeable or impermeable. If essentially all pores of a material have dead ends, the material is impermeable. In the contrary, if essentially all pores of a material have open ends, i.e. the pores are interconnected, the material is considered permeable. Consequently, if a fraction of the pores has dead ends, a material is considered partly permeable.

In an advantageous embodiment, the present invention provides microporous polymer structures, wherein at least 90% of the pores in the porous regions are interconnected.

The porosity, i.e. the volume of pores in relation to the volume of the structure in total, can be varied in a broad range. Inventive materials show porosity in the range of 10 to 95 vol.%, preferably 20 to 90 vol.%. The porosity may be determined by porosimetry.

The surface of the aforementioned nano- and/or microparticles may be functionalized. Surface functionalization of nano- and/or microparticles may be achieved by surface functionalizing reagents and techniques known to the skilled person. Suitable coating materials for said particles may be selected from anhydride acids, such as poly maleic anhydride acids (PMAH), its homopolymer but also co-polymer containing PMAH and mixture of PMAH, or carboxylic acids, such as C6-34 carboxylic acids, and mixtures of carboxylic acids. In the context of the present invention, PMAH may be linear or branched. Further, the co-polymer containing PMAH also contains other functional groups such as alkane, alkene functional groups. In the context of the present invention, carboxylic acids may be linear or branched. Further, carbocyclic acids may contain one or more double bonds. The term carboxylic acid further includes mono-carboxylic acids and dicarboxylic acids. Suitable carboxylic acids are selected from the group of naturally occurring fatty acids, such as stearic acid, and naturally occurring dicarboxylic acids, such as pimelic acid or sebacic acid. They may further be selected from the group of alkyl-aryl-alkoxy-silanes, aryl-alkoxy-silanes, alkyl-alkoxysilanes, and mixtures of such silanes. In the context of the present invention, these silanes may be selected from the group of trialkoxy-silane derivatives, dialkoxy-silane derivatives and monoalkoxy-silane derivatives. Further, these silane derivatives may be cyclic or linear and thus include corresponding oligomers. Suitable silanes are selected from the group of ((C$_{2^-16}$)alkyl)Si(OMe)$_3$, ((C$_2$-C$_{16}$)alkyl)Si(OEt)$_3$, ((C$_2$-C$_{16}$)alkyl)$_2$·Si(OMe)$_2$, (C$_2$-C$_{16}$)alkyl)$_2$·Si(OEt)$_2$ and corresponding, optionally substituted phenyl group containing derivatives, such as (C$_2$-C$_{16}$)alkyl)-Ph·Si(OMe)$_2$. For aryl-silanes, one or more of the above alkyl group is replaced by at least one phenyl or substituted phenyl group.

In a preferred embodiment of the method disclosed herein, at least one of the first composition and the second composition additionally comprises plain or functionalized fibers. Such fibers serve on the one hand to improve the mechanical properties of the final microporous polymer structure and on the other hand to adjust the rheological properties of the compositions, for example to slow down the deliquesce or running after application or enhance the shape retention of the applied composition.

In a preferred embodiment of the method disclosed herein, the second composition consists of the at least one second polymer and optionally one or more additives. The additives may be selected from the group consisting of surfactants, polymerisation initiators, stabilizers, cross-linking agents, wetting agents, thickener-, curing-, leveling-, film flow-, film uniformity-, anti-foaming-, anti-orange peel agents, and combinations thereof.

In a preferred embodiment of the method disclosed herein, the first composition comprises, preferably consists of:

- from 1 to 25% of the at least one first polymer;
- from 50% to 99% of the at least one solvent for the first polymer;
- from 0.5 to 40% of the one or more nano- and/or micro-particles;
- from 0 to 5% of additives;

each based on the total weight of the first composition.

Additionally or alternatively, the second composition may comprise, preferably consist of:

- from 1 to 35% of the at least one second polymer;
- from 50% to 99% of the at least one solvent for the second polymer;
- from 0 to 40% of the one or more nano- and/or microparticles;
- from 0 to 5% of additives;

each based on the total weight of the second composition.

The object is further achieved by a microporous polymer structure obtained by a method disclosed herein. The microporous polymer structure comprises a top surface and a bottom surface with a thickness between said top surface and said bottom surface. The microporous polymer structure further comprises at least one porous region formed from a first composition and a substantially non-porous support structure formed from a second composition, the substantially non-porous support structure extending over at least part of the thickness between the top surface and the bottom surface. The porous region comprises an anisotropic distribution of pore diameters from the top surface to the bottom surface along the direction of thickness between the top surface and the bottom surface.

Such a microporous polymer structure is characterized by both high filtration performance and high mechanical strength. The microporous polymer structure may in particular be a membrane.

In a preferred embodiment of the microporous polymer structure disclosed herein, the pore diameter at the top surface is in a comparatively smaller pore diameter range of 5 nm to 5000 nm and the pore diameter at the bottom surface is in a comparatively larger pore diameter range of 500 nm to 50000 nm. Accordingly, the pore diameter in the thickness between the top surface and the bottom surface is in a pore diameter range of 5 nm to 5000 nm.

In a preferred embodiment of the microporous polymer structure disclosed herein, the porous region has a porosity of between 10 volume percent to 90 volume percent, based on the total volume of the porous region.

In a preferred embodiment of the microporous polymer structure disclosed herein, the porous region constitutes at least 40% with respect to the total volume of the microporous polymer structure and the non-porous support structure constitutes at most 60% with respect to the total volume of the microporous polymer structure. Additionally or alternatively, the porous region extends over at least 40% based on the total coated substrate area and the non-porous support structure extends over at most 60% based on the total coated substrate area.

In a preferred embodiment of the microporous polymer structure disclosed herein, the substantially non-porous support structure is an integral part of the microporous polymer structure. In the context of the present invention, an integral part is understood to mean that at least part of the support structure is surrounded by the porous region on all accessible sides.

Such a microporous polymer structure is particularly stable and can in particular be free-standing.

In a preferred embodiment of the microporous polymer structure disclosed herein, the substantially non-porous support structure comprises a plurality of webs. Therein, a first set of webs is arranged substantially parallel to each other. Such a structure can be manufactured particularly efficiently and with high throughput in a continuous process by maintaining one or more means for applying the second composition in fixed relation to each other and to a movable substrate. By way of example, a manifold with a number of outlet openings corresponding to the number of parallel webs to form the substantially non-porous support structure can be used together with a moving substrate.

Optionally, a second set of webs is arranged substantially perpendicular to the webs belonging to the first set of webs. Thus, in the latter alternative, the webs of the non-porous support structure are arranged in a checkerboard or rhombic shape. Such a support structure can be manufactured particularly easily by two reciprocating means for applying the second composition transversely to a moving substrate, for example by means of two movable outlets or nozzles. Such a structure can be manufactured particularly efficiently and with high throughput in a continuous process.

The embodiment of the microporous polymer structure comprising webs may comprise at least two web that form boundary webs bounding the microporous polymer structure on at least two opposite sides. The boundary webs extend over the entire thickness of the porous regions. Preferably, the boundary webs close off the edges of the microporous polymer structure. In the case of a substantially planar microporous polymer structure such as a substantially flat membrane, this means that the boundary webs encompass the membrane all round in said plane. In the same embodiment, at least some of the webs arranged between the boundary webs extend over part of the thickness (d) of the porous regions. Moreover, substantially all the webs are interconnected.

The object is further achieved with a filtration device comprising at least one microporous polymer structure as disclosed herein. The at least one microporous polymer structure is attached to the filtration device via the non-porous support structure of said microporous polymer structure.

The filtration device may be a filter housing or a textile.

Membrane Preparation

A general procedure for the preparation of microporous polymer structures as disclosed herein is as follows:

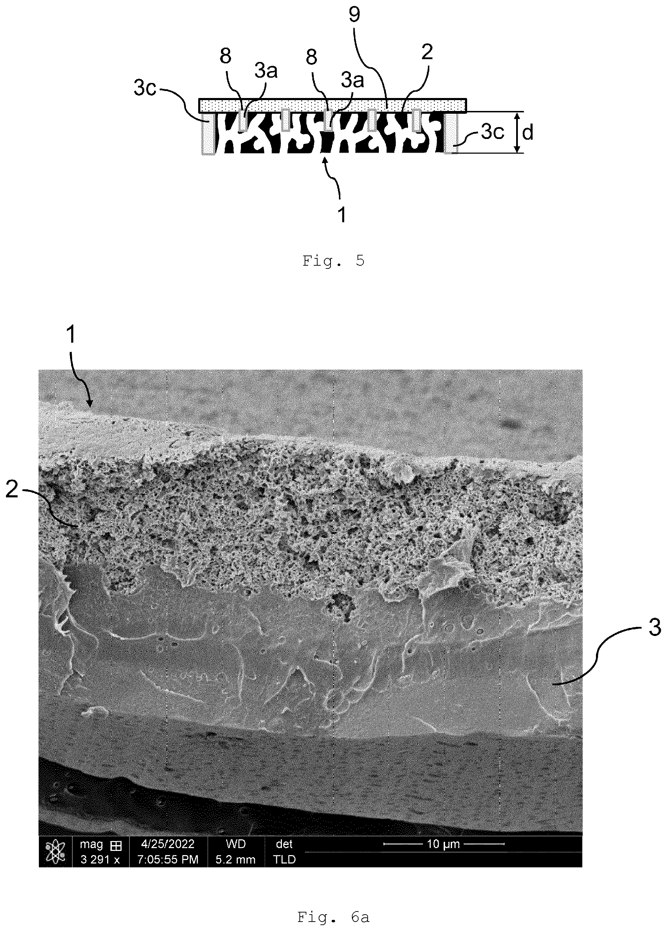

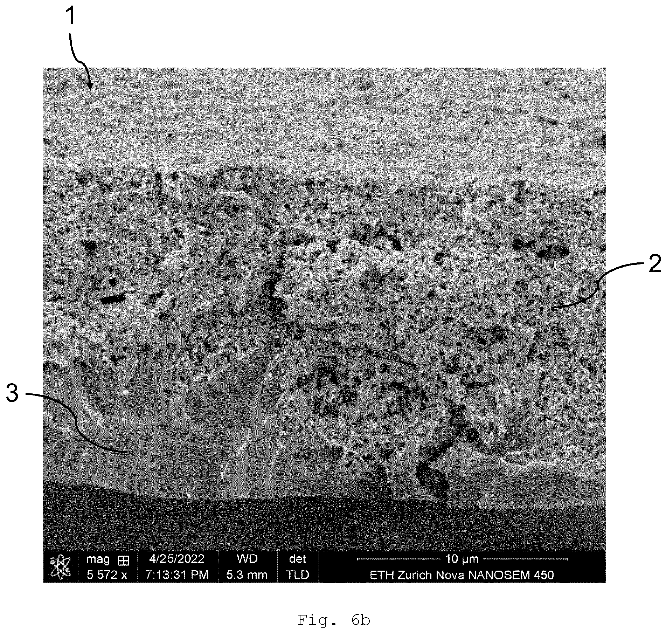

Polysulfone and polyvinylpyrrolidone (1:1) are mixed with N,N-dimethylacetamide and calcium carbonate (2:1 ratio of particles to polymers) to yield a concentration of 32.6 wt%. The mixture is then milled in a ball mill (WAB Dyno®-Mill Multi Lab at 10 rpm pumping rate and 3800 U/min milling rotation with 2 mm $ZrO_2$ milling beads) to result in a first composition. A second composition is provided by mixing polysulfone and polyvinylpyrrolidone (1:1) with N,N-dimethylacetamide to yield a concentration of 13.9 wt%. Both mixtures were simultaneously casted on a continuous pilot coater (Coatema GmbH, SC19), using a doctor blade set-up. The basket keeping the casting solution was divided into three segments, a wide segment in the center for the first composition and two smaller segments adjacent to each side of the wide segment, containing the second composition. The membrane was casted at a line speed of 0.1 m/min onto a PET support layer. The layer was then heated from below at 80°C for a period of 4 min before being dried at 110°C to 150°C for 10 min. The resulting composite is then placed in diluted sulfamic acid to remove the template for 5 minutes. The resulting membrane 1 was then washed in de-ionized water and dried on air for two hours. The resulting interface between porous region 2 and non-porous support structure 3 formed from the first and second composition, respectively, has been confirmed by scanning electron microscopy (Nanosem 450, FEI), as can be seen in Fig. 6a and Fig. 6b.

The present invention will be better understood with reference to the following description of preferred embodiments and the accompanying drawings, wherein the same reference numerals are used to denote the same or equivalent features amongst different embodiments and examples. In short:

Fig. 1    Flowchart illustrating the sequence of an embodiment of the method of manufacturing a porous polymer structure as disclosed herein;

Fig. 2a    Schematic illustration of steps b) through h) of the method disclosed herein;

Fig. 2b    Further schematic illustration of steps b) through h) of the method disclosed herein;

Fig. 3a    Top view of a microporous polymer structure precursor on a substrate;

Fig. 3b    Cross-section through the precursor shown in Fig. 3a along line A-A in Fig. 3a;

Fig. 3c    Cross-section through the precursor shown in Fig. 3b along line B-B in Fig. 3b;

Fig. 4    Cross-section through a free-standing embodiment of a microporous polymer structure disclosed herein;

Fig. 5    Cross-section through a further embodiment of a microporous polymer structure disclosed herein;

Fig. 6a    SEM image of a cross-section through a microporous polymer structure obtained by a method as disclosed herein;

Fig. 6b    SEM image of a cross-section through a microporous polymer structure obtained by a method as disclosed herein.

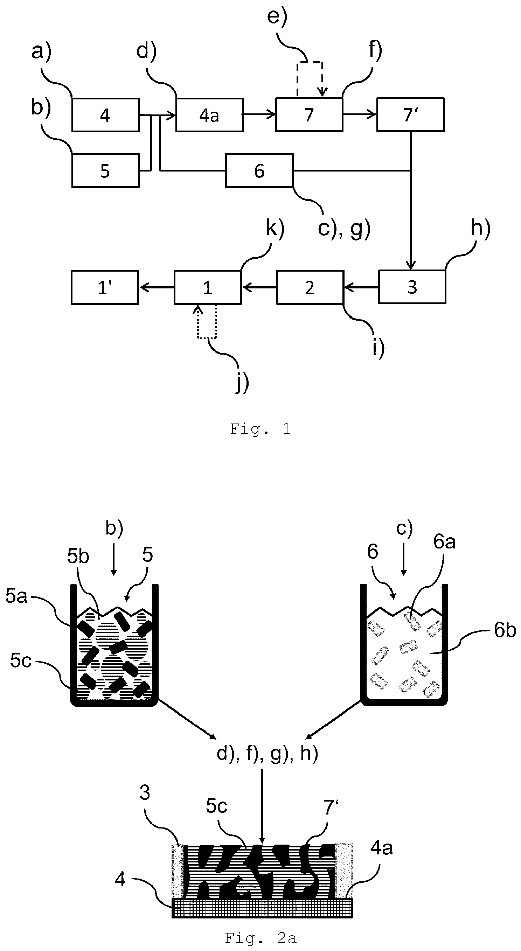

In Fig. 1 illustrates a flow chart of an embodiment of a method according to the present invention of manufacturing a porous polymer structure 1, which may in particular be a membrane. In the present example, the method comprises a step a) of providing a substrate 4. The substrate 4 may in particular be a porous or a non-porous substrate as disclosed herein and may be essentially flat, i.e. have a two-dimensional shape, or non-flat, i.e. have a three-dimensional shape. In a step b), a first composition 5 is provided, wherein the first composition comprises a first polymer, at least one solvent for said first polymer, and one or both of nanoparticles and microparticles dispersed therein. Subsequently, the first composition 5 is applied to a surface 4a of the substrate 4 to form a first coating layer 7 in a step d). Application of the first composition to the respective substrate surface 4a may be performed by any method known to the skilled person depending on the properties of the first composition 5, in particular the rheological properties. By way of example, the first composition 5 may be applied with a squeegee to a predefined thickness. Optionally, the first coating layer 7 may be subjected to an atmosphere promoting the evaporation of at least one of said solvents for said first polymer, such as a discharge flow or reduced pressure, as indicated by the dashed arrow e). Note that the optional step e) is not the same as the following step f), in which a phase separation is effected in the first coating layer 7 from one side of the first coating layer 7 to obtain a phase separated first coating layer 7'. Initiation of the phase separation may in particular be effected from the side of the substrate, as will be explained in more detail further below. Before or after this step f), a second composition 6 comprising a second polymer and optionally at least one solvent for said second polymer is provided in a step c). In step g), the second composition 6 is applied in a patterned manner to the same substrate surface 4a as previously the first composition 5. It is of course also conceivable that the first composition 5 and the second composition 6 be applied essentially simultaneously to the substrates surface 4a, i.e. that the steps d) and g) are performed in parallel. In addition or alternatively, the second composition 6 may also be applied in step g) onto, i.e. at least partially on top of, the phase separated first coating layer 7' obtained in step f). The second composition 6, i.e. the later-to-become non-porous support structure, and the first composition 5, i.e. the later-to-become porous regions, are arranged on the substrate 4 such that they form common interfaces, meaning that the first composition 5 and the second composition 6 are applied such that they are in contact with each other. In step h), the second composition 6 is physically hardened or cured to obtain a non-porous support structure 3 of the microporous polymer structure 1. Subsequently, in step i), the nanoparticles and/or microparticles comprised within the phase separated first coating layer are dissolved with aqueous solution to obtain a porous region 2 of the microporous polymer structure 1. Hence, the microporous polymer structure obtained this way has at least one porous region 2 and a substantially non-porous support structure 3 configured to support said at least one porous region 2, as will be described in detail further below. In an optional step j) indicated by the dotted arrow, the microporous polymer structure 1 comprising porous regions 2 and substantially non-porous regions 3 acting as support structure for the porous regions 2 may be dried. In the example illustrated in Fig. 1, the method further comprises a step k) of removing the microporous polymer structure 1 from the substrate 4 to obtain a free-standing microporous polymer structure 1'. As apparent from Fig. 1, step k) is performed after any one of steps g) to j).

Figure 2a is a schematic illustration of steps b) through h) of an embodiment of the method disclosed herein. On the top left of Fig. 2a, a first composition 5 is provided in a step b), wherein the first composition 5 is prepared by adding a first polymer 5a, a solvent 5b for said first polymer 5a, and a mixture of nanoparticles and microparticles 5c to a suitable vessel, such as a beaker or stirring kettle. On the top right of Fig. 2a, a second composition 6 is provided in a step c), wherein the second composition 6 is prepared by adding a second polymer 6a and a solvent 6b for said second polymer 6a. Similar to step b), any suitable vessel may be selected for dissolving the second polymer 6a in the solvent 6b. However, it is expressly not required that the second polymer 6a be provided dissolved in a solvent. For example, it is conceivable that the second polymer 6a and any additives contained or added therein essentially make up the second composition 6 and that the second composition 6 is applied in the molten state. The subsequent steps of applying the first and second compositions on the same surface side 4a of substrate 4 (steps d) and g), respectively), effecting a phase separation in the first composition to obtain phase separated first coating 7' (step f)), and physically hardening or curing the second composition 6 to obtain the non-porous support structure 3 (step h)) are not illustrated in Fig. 2a in detail but their implementation will be understood by the person skilled in the art. In case the second composition 6 is applied as a melt, for example provided by an extruder, the formation of the support structures 3 occur as a result of the solidification of the second composition 6 during cooling. In the example shown on the bottom of Fig. 2a, the precursor of the microporous polymer structure still contains the salt particles 5c of the first composition 5, which can be washed out in step i) to produce the microporous polymer structure. In the example shown on the bottom of Fig. 2a, the precursor and possibly also the microporous polymer structure obtained after washing out the salt particles is supported by substrate 4.

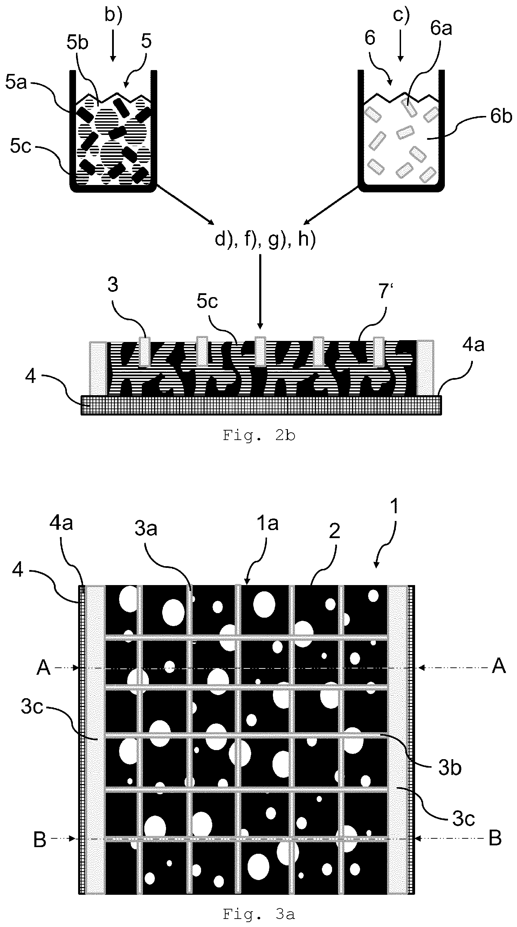

Figure 2b is a further schematic illustration of steps b) through h) of an embodiment of the method disclosed herein. The process steps b) to h) shown in Fig. 2b correspond to the process steps already described in Fig. 2a, with the exception that the second composition 6 was not only applied in a patterned manner to the same surface 4a of the substrate 4 as the first composition 5, but in addition to this also to the phase separated first coating layer 7'.

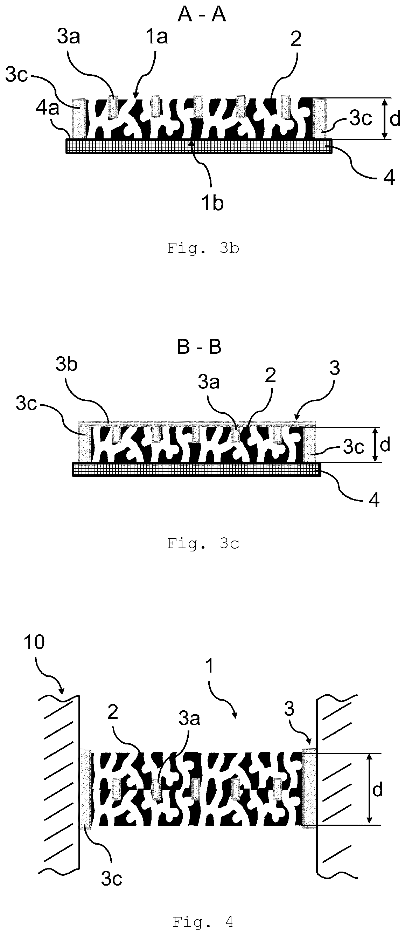

Figure 3a is a schematic top view on the top surface 1a of an embodiment of a microporous polymer structure 1 on a substrate 4. Both the first composition and the second composition (not shown) were applied on one side of the substrate 4, namely on surface 4a. The microporous polymer structure 1 illustrated in Fig. 3a comprises a substantially non-porous support structure formed from the second composition, the support structure comprising a plurality of webs 3a-3c. A first set of webs 3a is arranged substantially parallel to each other. The webs belonging to the first set of webs 3a that are furthest spaced apart are boundary webs 3c which bound the microporous polymer structure 1 on two opposite sides and extend over the entire thickness (d) of the porous regions 2, as shown and described in Figures 3b and 3c. In addition, a second set of webs 3b is arranged substantially perpendicular to the webs belonging to the first set of webs 3a. The porous regions 2 are at least partially separated by the webs 3a and 3b.

Figure 3b shows a cross-section through the microporous polymer structure 1 shown in Fig. 3a along line A-A in Fig. 3a. As can be seen from this view, the porous polymer structure 1 has a thickness d between the top surface 1a and the bottom surface 1b, wherein the bottom surface 1b is in contact with surface 4a of substrate 4. The thickness d means the extend of the porous regions 2. The porous region 2 comprises an anisotropic distribution of pore diameters from the top surface 1a to the bottom surface 1b along the direction of thickness d between the top surface 1a and the bottom surface 1b (anisotropic distribution of pore diameters not shown in the Figures due to schematic nature of the representations). As can be seen from the cross-section shown in Fig. 3b, the boundary webs 3c extend over the entire thickness d of the porous regions 2, whereas webs 3a that belong to the first set of webs and are arranged between the boundary webs 3c extend over part of the thickness d between the top surface 1a and the bottom surface 1b, i.e. over part of the thickness d of the porous regions 2.

Figure 3c shows a cross-section through the microporous polymer structure 1 shown in Fig. 3a along line B-B in Fig. 3a. The cross-section passes through a web 3b of the second set of webs, which are arranged substantially perpendicular to the webs belonging to the first set of webs 3a. As will be appreciated from the illustration shown in Fig. 3c in conjunction with Fig. 3a, all webs 3a-3c are interconnected and thus together form the substantially non-porous support structure 3 configured to support the porous regions 2. In addition to the support function of the support structure 3, another advantage of the microporous polymer structure 1 disclosed herein is that the support structure 3, in particular the boundary webs 3c, serves as a sealing area that is suitable for fixing and securely sealing the microporous polymer structure 1 in a filter housing. Such fastening to the support structure 3, which is much more thermally resilient than the porous regions 2, can be carried out by means of welding, for example, and without causing any negative effects on the porous regions 2. The non-porous support structure 3 and the porous regions 2 are arranged on the substrate 4 such that the non-porous support structure 3 and the porous regions 2 form common interfaces, meaning that they are in contact with each other. Optional removal of the microporous polymer structure 1 form the substrate 4 affords a free-standing microporous polymer structure.

Figure 4 shows a cross-section through a freestanding embodiment of a microporous polymer structure 1 disclosed herein. In this particular embodiment, the substantially non-porous support structure 3 is an integral part of the microporous polymer structure 1 as at least part of the support structure 3, namely the webs 3a, is surrounded by the porous region 2 on all accessible sides. Put differently, at least part of the support structure is embedded in the porous region 2. Such a configuration is obtainable by first applying a first coating layer of the first composition to a substrate, and then applying the second composition to the first coating layer as described above. A further coating layer of the first composition is applied before the phase separation is effected in the first coating layer. The remaining steps of the method described herein can also be carried out analogously for this embodiment. The webs 3a serve as a reinforcing backbone for the entire microporous polymer structure 1 and enhance its mechanical stability. As can also be seen from Fig. 4, the microporous polymer structure 1 is attachable by its boundary webs 3c to a surface, such as a filter housing of a filtration device 10.

Figure 5 shows a cross-section through a further embodiment of a microporous polymer structure 1 disclosed herein. In this particular example, the microporous polymer structure 1 is attached to a textile substrate 9 via attachment points 8 between said textile substrate 9 and at least some of the webs 3a of the substantially non-porous support structure 3. Attachment of the microporous polymer structure 1 to the textile 9 may be done before or after removing the support 4 (not shown) used in the method of manufacturing disclosed herein. Again, the thickness d between the top surface and the bottom surface of the microporous polymer structure 1 corresponds to the thickness of its porous region 2.

**Claims**

1. A method of manufacturing a microporous polymer structure (1), in particular a membrane, with at least one porous region (2) and a substantially non-porous support structure (3) configured to support said at least one porous region (2), the method comprising the steps of:

   a) providing a substrate (4);
   b) providing a first composition (5) comprising a first polymer (5a), at least one solvent (5b) for said first polymer, and one or both of nanoparticles and microparticles (5c) dispersed within said first composition (5);
   c) providing a second composition (6) comprising a second polymer (6a) and optionally at least one solvent (6b) for said second polymer;
   d) applying the first composition (5) to a surface (4a) of said substrate (4) to form a first coating layer (7);
   e) optionally, subjecting the first coating layer (7) to an atmosphere promoting the evaporation of at least one of said solvents (5b) for said first polymer (5a);
   f) effecting a phase separation in the first coating layer (7) to obtain a phase separated coating layer (7');
   g) applying, in a patterned manner, the second composition (6) to the same surface (4a) of said substrate (4) and/or onto the phase separated first coating layer (7');
   h) physically hardening or curing the second composition (6) applied in step g) to obtain the non-porous support structure (3);
   i) dissolving said nanoparticles and/or microparticles (5c) with a washing solvent, preferably acidic aqueous solution, to obtain the porous region (2); and
   j) optionally, drying the microporous polymer structure (1) obtained after step i);

   wherein said non-porous support structure and said porous regions are arranged on the substrate such that they form common interfaces, and wherein the phase separation in the first coating layer (7) in step f) is effected from one side of the first coating layer (7), preferably from the side of the substrate (4).

2. The method according to claim 1, further comprising the step of

   k) removing the microporous polymer structure (1) from the substrate (4) to obtain a free-standing microporous polymer structure (1');

wherein step k) is performed after any one of steps g) to j) .

3. The method according to claim 1 or 2, wherein step d) and step g) are performed simultaneously, followed by step f).

4. The method according to any one of the preceding claims, wherein phase separation in step f) is effected by applying heat of more than 40 °C to one side of the first coating layer (7), preferably from the side of the substrate (4).

5. The method according to any one of the preceding claims, wherein said second composition (6) comprises at least one of radiation-curable monomers, radiation-curable oligomers, and precursors of said second polymer (6a), and wherein curing of said second composition (6) in step h) is performed by radiation curing using ultraviolet (UV) light, preferably with a wavelength of 280 to 400 nm, or high-energy electrons from an electron-beam (EB) source.

6. The method according to any one of the preceding claims, wherein said nano- and/or microparticles (5c) are selected from the group consisting of oxides, carbonates, sulphates, halogenides, nitrates and phosphates, preferably oxides and carbonates, most preferably calcium carbonate ($CaCO_3$), barium carbonate ($BaCO_3$), strontium carbonate ($SrCO_3$), sodium carbonate ($Na_2CO_3$), potassium carbonate ($K_2CO_3$), sodium chloride (NaCl), zinc oxide (ZnO) and calcium oxide (CaO); and/or wherein said nano- and/or microparticles (5c) have a particle size of 1 to 5000 nm, preferably 5 to 600 nm.

7. The method according to claim 6, wherein the surface of said nano- and/or microparticles (5c) is functionalized.

8. The method according to any one of claims 1 to 7, wherein said second composition (6) consists of said at least one second polymer (6a) and optionally one or more additives (6c), in particular one or more additives selected from the group consisting of Suitable additives may be selected from a broad range of known additives and mixtures thereof and are known in the field. Particularly, additives may be selected from the group consisting of surfactants, polymerisation initiators, stabilizers, cross-linking agents, wetting agents, thickener-, curing-, leveling-, film flow-, film uniformity-, anti-foaming-, and anti-orange peel agents.

9. A microporous polymer structure (1), in particular a membrane, obtained by a method according to any one of claims 1 to 8, comprising:

- a top surface (1a) and a bottom surface (1b);
- a thickness (d) between said top surface (1a) and said bottom surface (1b);
- at least one porous region (2) formed from a first composition (5); and
- a substantially non-porous support structure (3) formed from a second composition (6);

wherein said porous region (2) comprises an anisotropic distribution of pore diameters from the top surface (1a) to the bottom surface (1b) along the direction of thickness (d) between the top surface (1a) and the bottom surface (1b), and wherein the substantially non-porous support structure (3) extends over at least part of the thickness (d) between the top surface (1a) and the bottom surface (1b).

10. The microporous polymer structure (1) according to claim 15, wherein the pore diameter at the top surface (1a) is in a comparatively smaller pore diameter range of 5 nm to 5000 nm, wherein the pore diameter at the bottom surface (1b) is in a comparatively larger pore diameter range of 500 nm to 50000 nm, and wherein the pore diameter in the thickness (d) between the top surface (1a) and the bottom surface (1b) is in a pore diameter range of 5 nm to 5000 nm.

11. The microporous polymer structure (1) according to any one of claims 9 to 10, wherein the porous region (2) constitutes at least 40% and the non-porous support structure (3) constitutes at most 60%, each based on the total volume of the microporous polymer structure; and/or wherein the porous region (2) extends over at least 40% and the non-porous support structure (3) extends over at most 60%, each based on the total coated substrate area.

12. The microporous polymer structure (1) according to any one of claims 9 to 11, wherein said substantially non-porous support structure (3) is an integral part of the microporous polymer structure (1).

13. The microporous polymer structure (1) according to any one of claims 9 to 12, wherein the substantially non-porous support structure (3) comprises a plurality of webs, wherein a first set of webs (3a) is arranged substantially parallel to each other, and wherein optionally a second set of webs (3b) is arranged substantially perpendicular to the webs belonging to the first set of webs (3a).

14. The microporous polymer structure (1) according to claim 13, wherein at least two of said webs are boundary webs (3c) which bound the microporous polymer structure (1) on at least two opposite sides and extend over the entire thickness (d) of the porous regions (2), preferably the boundary webs (3c) close off the edges of the microporous polymer structure, wherein at least some of the webs arranged between the boundary webs (3c) extend over part of the thickness (d) of the porous regions (2), and wherein substantially all the webs are interconnected.

15. A filtration device (10), in particular a filter housing or a textile, comprising at least one microporous polymer structure (1) according to any one of claims 9 to 12, wherein said at least one microporous polymer structure (1) is attached to said filtration device (10) via the non-porous support structure (3) of said microporous polymer structure (1).

Fig. 1

Fig. 2a

Fig. 2b

Fig. 3a

A - A

Fig. 3b

B - B

Fig. 3c

Fig. 4

Fig. 5

Fig. 6a

Fig. 6b

Europäisches
Patentamt

European
Patent Office

Office européen
des brevets

**EUROPEAN SEARCH REPORT**

Application Number

EP 23 15 0340

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2013/299417 A1 (LUCHINGER NORMAN ALBERT [CH] ET AL) 14 November 2013 (2013-11-14) * figure 1 * | 1-15 | INV. B01D63/08 B01D69/10 |
| X | US 2015/329381 A1 (KITANAKA ATSUSHI [JP] ET AL) 19 November 2015 (2015-11-19) * paragraphs [0061] - [0064], [0018], [0019], [0082], [0084]; figure 1b * * the whole document * | 1,2,4-15 | |
| X | US 2015/021260 A1 (IWAI KENTA [JP] ET AL) 22 January 2015 (2015-01-22) * paragraphs [0069] - [0078]; figures 1,3 * | 1,2,4-15 | |
| A | US 2014/263025 A1 (MAXWELL ERIC [US] ET AL) 18 September 2014 (2014-09-18) * paragraph [0060]; figure 5b * | 1-15 | |
| X | US 2011/049038 A1 (AERTS PETER E M [US] ET AL) 3 March 2011 (2011-03-03) * paragraphs [0019] - [0023]; figure 1 * | 1-15 | TECHNICAL FIELDS SEARCHED (IPC) B01D |
| X | US 2003/031600 A1 (MANGANINI STEVEN J [US] ET AL) 13 February 2003 (2003-02-13) * paragraphs [0031], [0032]; figures 1,2 * | 9,12,13, 15 | |
| A | US 2016/166965 A1 (ALLEN JOHN C [US] ET AL) 16 June 2016 (2016-06-16) * paragraphs [0046], [0034], [0036]; figure 4 * | 15 | |
| X | US 4 929 354 A (MEYERING MARK T [US] ET AL) 29 May 1990 (1990-05-29) * parts relating to figure 5; figure 5; example IV * | 1-10,12 | |

The present search report has been drawn up for all claims

| Place of search | Date of completion of the search | Examiner |
|---|---|---|
| Munich | 9 May 2023 | Hennebrüder, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
### ON EUROPEAN PATENT APPLICATION NO.

**EP 23 15 0340**

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2023

| Patent document cited in search report | Publication date | Patent family member(s) | Publication date |
|---|---|---|---|
| US 2013299417 A1 | 14-11-2013 | CA 2824182 A1 | 26-07-2012 |
| | | EP 2476724 A1 | 18-07-2012 |
| | | EP 2665767 A1 | 27-11-2013 |
| | | JP 5995872 B2 | 21-09-2016 |
| | | JP 2014509333 A | 17-04-2014 |
| | | US 2013299417 A1 | 14-11-2013 |
| | | WO 2012097967 A1 | 26-07-2012 |
| US 2015329381 A1 | 19-11-2015 | CN 104411643 A | 11-03-2015 |
| | | DK 2873650 T3 | 27-07-2020 |
| | | EP 2873650 A1 | 20-05-2015 |
| | | JP 6164216 B2 | 19-07-2017 |
| | | JP WO2014010554 A1 | 23-06-2016 |
| | | KR 20150036221 A | 07-04-2015 |
| | | US 2015329381 A1 | 19-11-2015 |
| | | WO 2014010554 A1 | 16-01-2014 |
| US 2015021260 A1 | 22-01-2015 | CN 104245101 A | 24-12-2014 |
| | | CN 105921025 A | 07-09-2016 |
| | | DK 2818230 T3 | 04-01-2021 |
| | | EP 2818230 A1 | 31-12-2014 |
| | | JP 6064902 B2 | 25-01-2017 |
| | | JP WO2013125506 A1 | 30-07-2015 |
| | | KR 20140130429 A | 10-11-2014 |
| | | US 2015021260 A1 | 22-01-2015 |
| | | WO 2013125506 A1 | 29-08-2013 |
| US 2014263025 A1 | 18-09-2014 | AU 2014237109 A1 | 17-09-2015 |
| | | BR 112015022126 A2 | 18-07-2017 |
| | | CA 2905872 A1 | 25-09-2014 |
| | | CL 2015002662 A1 | 26-02-2016 |
| | | CN 105050694 A | 11-11-2015 |
| | | CN 108514819 A | 11-09-2018 |
| | | EP 2969146 A1 | 20-01-2016 |
| | | JP 2016511146 A | 14-04-2016 |
| | | KR 20150131053 A | 24-11-2015 |
| | | PE 20151711 A1 | 18-11-2015 |
| | | SG 10201707581P A | 29-11-2017 |
| | | SG 11201506981S A | 29-10-2015 |
| | | US 2014263025 A1 | 18-09-2014 |
| | | US 2019358594 A1 | 28-11-2019 |
| | | WO 2014150475 A1 | 25-09-2014 |
| US 2011049038 A1 | 03-03-2011 | CN 102481522 A | 30-05-2012 |
| | | US 2011049038 A1 | 03-03-2011 |
| | | WO 2011025698 A1 | 03-03-2011 |

EPO FORM P0459

For more details about this annex : see Official Journal of the European Patent Office, No. 12/82

**page 1 of 2**

## ANNEX TO THE EUROPEAN SEARCH REPORT
## ON EUROPEAN PATENT APPLICATION NO.

EP 23 15 0340

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2023

| Patent document cited in search report | Publication date | Patent family member(s) | | Publication date |
|---|---|---|---|---|
| US 2003031600 A1 | 13-02-2003 | NONE | | |
| US 2016166965 A1 | 16-06-2016 | AU | 2015363263 A1 | 29-06-2017 |
| | | CA | 2969932 A1 | 23-06-2016 |
| | | CN | 106999829 A | 01-08-2017 |
| | | EP | 3233254 A1 | 25-10-2017 |
| | | JP | 6442077 B2 | 19-12-2018 |
| | | JP | 2018500168 A | 11-01-2018 |
| | | US | 2016166965 A1 | 16-06-2016 |
| | | WO | 2016099769 A1 | 23-06-2016 |
| US 4929354 A | 29-05-1990 | NONE | | |

EPO FORM P0459

For more details about this annex : see Official Journal of the European Patent Office, No. 12/82

page 2 of 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6267916 B1
- US 5444097 A
- EP 2665767 A1
- EP 1666129 B1
- US 6736971 B2
- US 8123992 B2
- WO 0242530 A1

**Non-patent literature cited in the description**

- **G. TKACIK ; S. MICHAELS.** *Nature Biotechnology.,* 1991, vol. 9, 941-946